# EUROPÄISCHE PATENTSCHRIFT

(11) **EP 2 739 983 B1**
(45) Veröffentlichungstag und Bekanntmachung des Hinweises auf die Patenterteilung: **23.03.2016**
(21) Anmeldenummer: 12748641.3
(22) Anmeldetag: 01.08.2012
(51) Int. Cl.: G01R 31/12, G01R 31/34, G01R 27/28, G01R 31/28, G01R 31/02, G01R 31/06

(54) **VERFAHREN UND VORRICHTUNG ZUR ERKENNUNG EINER ZUSTANDSVERSCHLECHTERUNG EINER ISOLIERUNG IN EINER ELEKTRISCHEN MASCHINE IM BETRIEB**
METHOD AND DEVICE FOR DETECTING A DETERIORATION IN THE STATE OF AN INSULATION IN AN OPERATING ELECTRIC MACHINE
PROCÉDÉ ET DISPOSITIF SERVANT À DÉTECTER UNE DÉGRADATION DE L'ÉTAT DE L'ISOLATION DANS UNE MACHINE ÉLECTRIQUE EN FONCTIONNEMENT

(30) Priorität: 01.08.2011 AT 11202011
(43) Veröffentlichungstag der Anmeldung: 11.06.2014
(73) Patentinhaber: Technische Universität Wien, 1040 Wien (AT)
(72) Erfinder: WOLBANK, Thomas, A-1050 Vienna (AT)
(74) Vertreter: Sonn & Partner Patentanwälte
(86) Internationale Anmeldenummer: PCT/AT2012/000201
(87) Internationale Veröffentlichungsnummer: WO 2013/016750

(56) Entgegenhaltungen:
- EP-A1- 2 405 570
- JP-A- 57 008 464
- JP-A- 57 153 271
- JP-A- 2005 037 351
- US-B1- 6 466 034
- STEFAN GRUBIC ET AL: "Investigation on surge testing for winding insulation fault detection in an online environment", ENERGY CONVERSION CONGRESS AND EXPOSITION, 2009. ECCE. IEEE, IEEE, PISCATAWAY, NJ, USA, 20. September 2009 (2009-09-20), Seiten 3255-3261, XP031888057, DOI: 10.1109/ECCE.2009.5403136 ISBN: 978-1-4244-2893-9

## Beschreibung

Die Erfindung betrifft ein Verfahren gemäß dem Oberbegriff von Anspruch 1 sowie eine Vorrichtung gemäß dem Oberbegriff von anspruch 10, zum Online-Testen einer Isolierung in bzw. an einer elektrischen Maschine, d.h. zum Testen der Isolierung während des Betriebs der Maschine.

Ein solches Verfahren bzw. eine solche Vorrichtung sind aus Grubic S. et al., "Investigation on surge testing for winding isulation fault detection in an online environment", ENERGY CONVERSION CONGRESS AND EXPOSITION, 2009, ECCE. IEEE, IEEE, PIS-CATAWAY, NJ. USA, 20. Sept. 2009 (2009-09-20), Seiten 3255-3261, XP031888057, bekannt. Dabei sollen Isolierungsfehler bei elektrischen Maschinen vor allem in Offline-Tests ermittelt werden. Ein Vorschlag geht jedoch auch dahin, in einem Online-Test die Maschine mit einem kurzen Spannungs- bzw. eigentlichen Stromimpuls anzuregen, der durch ein Entladen von eigens dafür vorgesehenen Kondensatoren bewirkt wird. Dabei wird eine Schwingung mit einer Frequenz von bis zu 50 kHz bewirkt, wobei in diesem Frequenzbereich das elektrische Verhalten der Maschine von der Induktivität der Wicklung bestimmt wird. Es wird angeführt, dass der Online-Stoßtest zur Detektion von Windungsfehlern genützt werden kann, wobei ca. 10% der Windungen kurzgeschlossen sind.

Umrichter-gesteuerte elektrische Maschinen werden in verschiedensten Gebieten immer häufiger verwendet. Insbesondere werden solche Antriebssysteme nicht nur standardmäßig in der Industrie eingesetzt, sondern auch in Traktionssystemen, insbesondere aber in sicherheitskritischen Einrichtungen. Dabei wird es immer wichtiger, diese Systeme präventiv hinsichtlich ihres Zustandes zu überwachen und in Stand zu halten. Ein Hauptgrund für den Ausfall derartiger Maschinen liegt immer wieder in der Verschlechterung von Isolierungen, insbesondere an den Statorwindungen. Untersuchungen haben gezeigt, dass ungefähr 30 bis 40 % aller Ausfälle Stator-bezogen sind, wobei hiervon ungefähr 70 % wiederum durch Verschlechterungen oder Fehler in der Windungsisolierung und in der Isolierung zur Masse zu finden sind.

Die Isolierung der Statorwindungen ist besonders hohen Beanspruchungen ausgesetzt, wenn ein Betrieb mit einem Umrichter gegeben ist. Dabei sind thermische, elektrische, mechanische und umweltbedingte Beanspruchungen von Bedeutung. Diese Beanspruchungen führen mit der Zeit zu einer Verschlechterung der Isolierung und können zu einem ernsthaften Ausfall der Maschine bzw. des gesamten Antriebssystems mit der Maschine führen.

Verschlechterungen von Isolierungszuständen können aber nicht nur innerhalb von Wicklungen auftreten, sondern auch im Bereich von Zuleitungen bzw. Verkabelungen. Auch hier sind Isolierungsverschlechterungen bzw. -fehler Grund für den Ausfall einer Maschine, und daher wären auch hier Änderungen im Isolierungszustand möglichst rasch zu detektieren.

Im Stand der Technik wurden bereits verschiedene Online- und Offline-Verfahren zur Detektion von Isolierungsfehlern vorgeschlagen, wobei eine Aufstellung und Bewertung der verschiedenen Techniken beispielsweise im Artikel Grubic S. et al., "A Survey on Testing and Monitoring Methods for Stator Insulation Systems of Low-Voltage Induction Machines Focusing on Turn Insulation Problems," IEEE Transactions on Industrial Electronics, Band 55, Nr. 12, Seiten 4127-4136, 2008, geoffenbart ist. Die Feststellung einer Verschlechterung einer Isolierung, nämlich insbesondere zwischen einzelnen Windungen einer Wicklung, wird hierbei in erster Linie als mittels Offline-Tests möglich erläutert; als Online-Test für derartige Maschinen wird das sog. PD-Verfahren (PD - Partial Discharge - Teilentladung) genannt, wobei als Nachteil die zusätzliche teure Ausrüstung, die hierfür notwendig ist, angeführt wird. Im Wesentlichen ergibt sich jedoch aus dieser Literaturstelle, dass vor allem Offline-Verfahren zielführend sind, wie insbesondere der sog. Stoßspannungstest (Surge Test). Von Nachteil ist bei einer derartigen Offline-Überprüfung, dass diese Überprüfungen oder Tests nicht laufend, sondern bloß in relativ großen Zeitabständen durchgeführt werden können. Wichtig wäre jedoch eine mehr oder weniger kontinuierliche Überwachung, also eine Online-Überwachung, zur Erkennung von etwaigen Zustandsverschlechterungen einer Isolierung.

Aus Grubic S. et al., "A New Concept for Online Surge Testing for the Detection of Winding Insulation Deterioration", Energy Conversion Congress arid Exposition (ECCE), Seiten 2747-2754, 2010, ist ein Konzept zum Online-Testen im Hinblick auf die Detektion einer Verschlechterung in einer Wicklungsisolierung bekannt. Bei dieser Technik werden verschiedene Formen von Zu- und Abschaltungen von elektrischen Bauelementen, insbesondere Induktivitäten, im Spannungsversorgungskreis (Speisekreis) vorgeschlagen, dabei auch beispielsweise das zusätzliche Trennen des Motors von der Versorgung. Erforderlich ist hier das Anlegen mehrerer Impulse mit steigendem Spannungspegel an den Motor. Diese Technik ist relativ umständlich und zeitaufwändig.

In der JP 2010-268645 A ist eine Technik zur Überprüfung von Isolierungen bei Wechselstrommotoren, insbesondere von Kraftfahrzeugen, beschrieben. Im Einzelnen wird hier der Zustand der Wicklungsisolation der elektrischen Maschine gegenüber dem Maschinengehäuse, also Masse, erfasst, wobei immer der Strom in einem neutralen Punkt (Nullpunkt) erfasst wird; dabei können auch Einschwingvorgänge dieses Nullpunkt-Stroms zur Folge einer Anregung ausgewertet werden, wobei eine Dämpfungsgröße berechnet wird. Die erforderliche Messgröße kann entweder durch Messung des Summenstroms zwischen Inverter und Maschine, oder durch Messung des Stroms zwischen Maschinengehäuse und Masse, oder durch Messung des Stroms zwischen Invertergehäuse und Masse erfasst werden, wobei jeweils ein eigener, zusätzlicher Sensor notwendig ist. Eine Verschlechterung der Isolation ist nur durch Vergleich von Messgrößen von mindestens zwei Motoren möglich.

Aus der US 6,483,319 B1 ist ein Verfahren zur Durchführung von Breitband-Impedanzantwort-Tests bekannt, um einen etwaigen bevorstehenden Ausfall einer Statorwindung zu erkennen. Die Impedanzantwort kann durch Anlegen von diskreten Frequenzen an die Statorwicklung erhalten werden, wobei allerdings eine geringe Auflösung die Folge ist.

In der WO 03/087855 A1 ist die Messung von Strömen in einem Motor regler beschrieben, wobei auch geoffenbart ist, zur Reduktion des Signal/Rausch-Verhältnisses beim Messsignal eine Überabtastung vorzusehen. Die Untersuchung von Isolierungszuständen ist hier nicht angesprochen.

In der RU 2208236 C2 ist beschrieben, bei der Diagnose der Isolierung von Wicklungen von Elektromotoren die Spannungssignale einer steilen Spannungswelle auszuwerten, weshalb zusätzlich eine Spannungsmessung an den Klemmen des Motors zu installieren ist.

Zu erwähnen ist hier noch die nicht vorveröffentlichte ältere EP-Anmeldung 10450114.3 bzw. die dieser entsprechenden PCT-Anmeldung WO/EP2010/061502(vgl. auch P. Nussbaumer et al. "Saliency Tracking based Sensorless Control of AC Machines Exploiting Inverter Switching Transcients", Proceedings of IEEE Symposium on Sensorless Control for Electrical Drives, SLED, 2010, Seiten 238-242), wo - anders als bei der vorliegenden Problematik der Isolierungsüberwachung - das Auffinden von Asymmetrien in einer Wechselstrommaschine mit Hilfe von transienten zeitlichen Ableitungen des Stroms erläutert wird, die bei Anlegen von Spannungssprüngen an der Maschine in deren Wicklung hervorgerufen werden. Dabei wird der transiente Verlauf der zeitlichen Ableitung des Stroms mit einer vergleichsweise hohen Abtastfrequenz abgetastet, um möglichst aussagekräftige digitale Werte für die zeitliche Stromänderung, bezogen auf ein kurzes Beobachtungsfenster, zu erhalten. Sich entwickelnde Isolierungsfehler können so jedoch nicht aufgefunden werden.

Es ist daher Aufgabe der Erfindung, ein Verfahren bzw. eine Vorrichtung wie eingangs eingegeben vorzuschlagen, mit dem bzw. mit der eine zuverlässige Online-Erkennung von Zustandsverschlechterungen von Isolierungen im Bereich einer elektrischen Maschine erkannt werden können, wobei überdies der apparative Aufwand möglichst gering gehalten werden können soll.

Die Erfindung basiert dabei darauf, dass die Konfiguration eines Antriebssystems mit Umrichter und Induktionsmaschine durch ein komplexes Netzwerk von Widerständen, Induktivitäten und Kapazitäten repräsentiert wird. Dabei hat beispielsweise die Topologie und Ausbildung des Umrichters einen Einfluss auf seine parasitäre kapazitive Kopplung zur Masse. Die Isolierung der Maschine beeinflusst die parasitären Kapazitäten Phase zur Masse, Phase zu Phase und Windung zu Windung (allgemeine Wicklungsisolation bzw. Isolation der einzelnen Windungen untereinander der sog. "Inter-Turn-Isolation"). Die sehr kurzen Anstiegszeiten der Spannungsimpluse, die beim Schalten des Umrichters an die Maschinenwicklungen angelegt werden, führen zu Reflexionen und damit zu hochfrequenten Schwingungen, und zwar nicht nur in der angelegten Spannung, sondern entsprechend auch im in den jeweiligen Wicklungen hervorgerufenen Strom. Wenn sich nun ein Element in dem vorerwähnten komplexen Netzwerk ändert, nämlich insbesondere durch eine sich verschlechternde Inter-Turn-Isolierung, wird das gesamte System "verstimmt", wobei sich eine Änderung in den vorerwähnten hochfrequenten, transienten Schwingungen des Stroms ergibt.

Andererseits ist erwähnenswert, dass bei den meisten heutigen Antriebssystemen im Speisekreis bereits Stromsensoren oder Sensoren, die zeitliche Ableitung des Stroms erfassen, vorliegen, wobei diese Sensoren zweckmäßiger Weise auch für die vorliegende Technik der Online-Erkennung von Zustandsverschlechterungen von Isolierungen eingesetzt werden können sollen.

Zur Lösung der gegebenen Aufgabe sieht die Erfindung ein Verfahren bzw. eine Vorrichtung wie in den unabhängigen Ansprüchen angegeben vor. Vorteilhafte Ausführungsformen sind Gegenstand der abhängigen Ansprüche.

Kurz gesagt sieht die Erfindung somit vor allem ein Verfahren zur Online-Erkennung einer Zustandsverschlechterung einer Isolierung in einer elektrischen Maschine vor, wobei mit Hilfe eines Umrichters eine stufenförmige Spannung an die Wicklung(en) der Maschine angelegt und der dadurch hervorgerufene Strom und/oder dessen zeitliche Ableitung als Messsignal mit Hilfe von wenigstens einem Sensor erfasst und sodann mit einer im Vergleich zu den für ein Einschwingen charakteristischen Frequenzen hohen Frequenz überabgetastet wird, wonach das durch die Überabtastung erhaltene Signal hinsichtlich Kenngrößen des Einschwingvorgangs, wie Überschwingen und/oder Eigenfrequenz und/oder Dämpfungskonstante, zur Erkennung einer etwaigen Isolierungsverschlechterung ausgewertet wird.

In entsprechender Weise wird eine Vorrichtung zur Online-Erkennung einer Zustandsverschlechterung einer Isolierung in einer elektrischen Maschine bereitgestellt, wobei der elektrischen Maschine ein Speisekreis mit einem Umrichter sowie zumindest ein Sensor in einer Strömleitung zur Maschine zugeordnet ist, welcher Sensor bei Anlegen einer stufenförmigen Spannung den in zumindest einer Wicklung der Maschine hervorgerufenen Strom oder dessen zeitliche Ableitung als Messsignal erfasst, wobei mit dem Sensor eine Überabtasteinrichtung zum Überabtasten des Messsignals mit einer relativ zu Einschwingvorgängen vergleichsweise hohen Frequenz verbunden ist und die erhaltenen Abtastwerte einer Recheneinheit zur Ermittlung von Kenngrößen des Einschwingvorgangs beim Anlegen der stufenförmigen Spannung, wie Überschwingen und/oder Eigenfrequenz und/oder Dämpfungskonstante, zur Erkennung einer etwaigen Isolierungsverschlechterung zugeführt werden.

Die vorgeschlagene Technik zur Isolationsfehlerdetektion bzw. genauer Detektion einer Isolierungsverschlechterung benützt somit Änderungen in der "Stufenstromantwort" auf die angelegte stufenförmige Spannung, wie Eigenfrequenz bzw. Dämpfungsrate, Überschwingen, aber auch - zur tatsächlichen Fehlererkennung - von Werten im eingeschwungenen Zustand (stationären Zustand) zufolge einer auf einen (beginnenden) Fehler zurückzuführenden Änderung in einem Element des vorgenannten komplexen Systems zur IsolierungsÜberwachung. Die Stufenantwort auf die Umrichter-Schalthandlung wird dabei mit Stromsensoren oder aber Stromableitungs-Sensoren erfasst, vorzugsweise mit Sensoren, die im Versorgungskreis der Maschine bereits vorhanden sind. In diesem Zusammenhang ist es günstig, dass bei der vorliegenden Technik Phasenströme ausgewertet werden, so dass gesonderte Sensoren entfallen können. Dabei ist es auch möglich, verschiedene Umrichter-Schalthandlungen zugrunde zu legen und die Systemreaktion auf diese stufenförmigen Spannungsänderungen zu erfassen, und zwar mit vergleichsweise hohen Abtastraten, im Bereich von mehreren MHz (bzw. MS/s - Megasamples pro Sekunde), wobei Änderungen in den Kenngrößen der hochfrequenten Stromschwingung detektiert werden können. Besonders bevorzugt werden als Sensoren sog. Rogowski-Typ-Sensoren verwendet, mit denen die zeitliche Ableitung der Ströme erfasst werden kann. Diese Rogowski-Sensoren werden auch als CDI-Sensoren bezeichnet (CDI - Current Derivative Inspector). Bei durchgeführten Tests erwiesen sich Abtastungen mit einer Abtastfrequenz von 40 MHz als günstig, wogegen die Schwingungsfrequenzen bei den ausgelösten Stromschwingungen beispielsweise in der Größenordnung von 100 oder 200 kHz liegen.

Ein Vorteil der vorliegenden Technik ist auch darin gelegen, dass die Isolation zwischen den Phasen und auch die Isolation zwischen den Windungen einzelner Phasen, abgesehen von der Isolation zwischen Wicklung und Masse, erfasst werden können. Es werden Unterschiede in der Impedanz zwischen Wechselrichter (Umrichter, Inverter) und Motor, die zu Reflexionen der steilen Spannungswelle an den einzelnen Windungen der Wicklung führen, in den entsprechenden Phasenstromsignalen erfasst. Überdies ist in diesem Zusammenhang auch von Vorteil, dass die Prüfung auf eine Isolierungsverschlechterung auch im Fall bloß einer elektrischen Maschine möglich ist, wobei durch einen Vergleich der Kenngrößen der einzelnen Phasenströme des betreffenden Motors eine Verschlechterung der Wicklungsisolation einer Phase in Form einer Asymmetrie der Isolationseigenschaft detektiert werden kann.

Zur beschriebenen hochfrequenten Überabtastung können beispielsweise hochfrequent abtastende A/D-Konverter (nachstehend auch kurz "ADC") eingesetzt werden, die zusätzlich mit den kostengünstigen Strom- bzw. Stromableitungs-Sensoren zu verwenden sind.

Für die (eigentliche) Datenverarbeitung können an sich herkömmliche, preiswerte logische Schaltungen bzw. Rechnermittel eingesetzt werden, so dass der Aufwand für die Ausführung der Erfindung außerordentlich gering und kostengünstig ist.

Nichtsdestoweniger wird auf diese Weise zum ersten Mal eine laufende, sichere Erkennung von Fehlern an einer Wicklungsisolation bereits bei deren Entstehen ermöglicht, wenn eine Schwächung der Isolation, einer Veränderung der Isolations-Kapazität, des Widerstands, der Induktivität etc. vorliegt. Wie erwähnt ist dabei die Inter-Turn-Isolierung besonders kritisch, und ein Kurzschluss zwischen Windungen gilt als besonders kritischer Fehler, der speziell bei großen Maschinen eine sofortige Reaktion erfordert, um eine vollständige Zerstörung von Wicklungen und Blechpaketen zu verhindern. Mit der Erfindung kann diese Problematik gelöst werden, und zwar ohne den früheren erheblichen Zusatzaufwand, wie etwa mit spezieller Verdrahtung von Maschine und Umrichter, ohne die früher notwendigen hochpräzisen Stromsensoren, und insbesondere ohne die typischen Unterbrechungen des Betriebs.

Als Kenngrößen des Einschwingvorgangs werden bei der vorliegenden Technik insbesondere das Überschwingen bzw. die Eigenfrequenz der Schwingung herangezogen, wobei als Alternative zur Eigenfrequenz oder aber als Ergänzung hierzu auch die Dämpfungskonstante der transienten Schwingung genutzt werden kann. Mit diesen Kenngrößen kann ein beginnender Fehler in der Isolierung sofort und sicher festgestellt werden.

Dabei hat es sich für eine sichere Erkennung als besonders vorteilhaft erwiesen, wenn die durch die Auswertung erhaltenen Kenngrößen mit entsprechenden Kenngrößen verglichen werden, die in einem früheren Messvorgang, bei ordnungsgemäß funktionierender Maschine, gewonnen wurden. Ein derartiger Vergleich kann einfach durchgeführt werden und ergibt somit einen unmittelbaren Hinweis auf geänderte Systemreaktionen, wenn die verglichenen Kenngrößen unterschiedlich sind.

Zusätzlich oder anstattdessen ist es auch für eine einfache Online-Erkennung günstig, wenn die erhaltenen Kenngrößen mit vorgegebenen Schwellenwerten verglichen werden, bei deren Überschreiten auf einen Fehlerzustand entschieden wird. Die vorgegebenen Schwellenwerte können dabei für jede einzelne Maschine aufgrund von einfachen Berechnungen oder Tests im Vorhinein festgelegt werden, wobei erst bei Überschreiten dieser Schwellenwerte auf einen Fehlerzustand oder einen beginnenden Fehler entschieden wird; damit können innerhalb von Toleranzgrenzen liegende Abweichungen der Kenngrößen als ungewollte Indikatoren für sich entwickelnde Fehler ausgeschieden werden. Beispielsweise können auch durch betriebsbedingte Erwärmung hervorgerufene Änderungen der Kenngrößen berücksichtigt werden.

Die Eigenfrequenz kann ganz einfach durch Bestimmung des zeitlichen Abstands zwischen aufeinanderfolgenden Extremwerten des Messsignals ermittelt werden. In ähnlicher Weise kann auf einfache Weise das Überschwingen als Differenz zwischen dem Wert im eingeschwungenen Zustand und den (ersten) Extremwert im (überabgetasteten) Signal ermittelt werden.

Mit der vorliegenden Technik können auch bereits vorhandene, also nicht nur beginnende, Isolierungsfehler erkannt werden, wobei es hierfür von Vorteil ist, wenn als Kenngröße, zur Erkennung von tatsächlichen Isolierungsfehlern, der eingeschwungene (stationäre) Zustand des Signals herangezogen wird. Dabei ist es weiters für eine einfache Fehlererkennung günstig, wenn der Wert des Signals im eingeschwungenen Zustand im Fall der Erfassung der zeitlichen Ableitung des induzierten Stroms als der letzte gemessene Wert bei Anlegen einer konstanten Spannung ermittelt wird. Andererseits ist es hierfür auch vorteilhaft, wenn der Wert des Signals im eingeschwungenen Zustand im Fall der direkten Erfassung des induzierten Stroms über zwei beabstandete Abtastwerte und die durch diese definierte Steigung im Signal ermittelt wird.

Eine vorteilhafte Ausführungsform des vorliegenden Verfahrens zeichnet sich sodann dadurch aus, dass mehrere Messvorgänge mit Anlegen einer stufenförmigen Spannung vorgenommen werden und eine statistische Auswertung der erhaltenen Ergebnisse durchgeführt wird. Auf diese Weise können mehr charakteristische Informationen hinsichtlich Erkennung von (beginnenden) Fehlern gewonnen werden, wobei auch die Sicherheit der Detektion verbessert wird.

Was die vorliegende Vorrichtung anlangt, so zeichnet sich diese in entsprechender Weise für die einfache Ermittlung in besonderer Weise durch wenigstens eine Vergleichseinheit aus, die zum Vergleichen der erhaltenen Kenngrößen mit entsprechenden gespeicherten Kenngrößen der Maschine bei ordnungsgemäßer Funktion und/oder mit einem vorgegebenen Schwellenwert aus. An die Vergleichseinheit ist mit Vorteil eine Auswerteeinheit zur Erkennung bzw. Identifizierung von Isolierungsverschlechterungen und ggfs. Isolierungsfehlern angeschlossen.

Zur zeitlichen Beschränkung der durchgeführt Online-Tests auf die wesentlichen Vorgänge beim Auslösen der Einschwingvorgänge wird zweckmäßiger Weise eine Fensterschaltung zwischen der Überabtasteinrichtung und der (eigentlichen) Recheneinheit vorgesehen, wobei die Fensterschaltung mit einem Steuereingang an eine den Umrichter ansteuernde Steuereinheit angeschlossen ist und ein vorgegebenes Beobachtungsfenster, beginnend mit einem Steuersignal der Steuereinheit, festlegt, in dem die Abtastwerte der Weiterverarbeitung zugeführt werden.

Wie bereits angedeutet kann die Recheneinheit im vorliegenden Fall mit einfachen, kostengünstigen Bauteilen ausgeführt werden, wobei insbesondere eine Ausführung mit einer FPGA-Komponente (Field programmable gate array - frei programmierbares Verknüpfungsfeld) günstig ist. Gegebenenfalls kann anstatt dessen oder aber auch zusätzlich ein digitaler Signalprozessor (DSP) für die Durchführung zumindest eines Teils der Berechnungen vorgesehen sein.

Die Erfindung wird nachfolgend anhand von besonders bevorzugten Ausführungsbeispielen, auf die sie jedoch nicht beschränkt sein solle, und unter Bezugnahme auf die Zeichnungen noch weiter erläutert. Es zeigen:
Fig. 1 ein blockschaltbildartiges Schema einer Ausführungsform der erfindungsgemäßen Vorrichtung;
Fig. 1A einen Teil einer Detektorschaltung bzw. Recheneinheit einer solchen Vorrichtung in einer konkreteren, etwas modifizierten Ausführungsform;
Fig. 2 schematisch ein Messsignal, wie es mit einem Rogowski-Sensor (CDI-Sensor) erhalten wird, und das die zeitliche Ableitung des induzierten Stroms, di/dt, in beliebigen Einheiten ("arbitrary units" - "a.u.") darstellt;
Fig. 2A einen Ausschnitt aus dem di/dt-Signal von Fig. 2 in einem zeitlich gedehnten Maßstab, zur Veranschaulichung der hochfrequenten Abtastpunkte für dieses Signal in einem praktischen Verhältnis der hohen Überabtast-Frequenz zur Frequenz des Einschwingvorgangs;
Fig. 3 ein zu Fig. 2 ähnliches Signal, d.h. einer zeitlichen Ableitung des induzierten Stroms, mit darin eingezeichneten Kenngrößen, nämlich ΔT als Kehrwert der Frequenz der Eigenschwingung, einen Überschwinger Δh und einen stationären Wert Y_{∞};
Fig. 4 schematisch ein vergleichbares Messsignal über der Zeit, wie es mit einem einfachen Stromsensor erhalten wird, wobei ebenfalls Δh und ΔT veranschaulicht sind;
Fig. 5 schematisch die Anordnung von drei Wicklungen einer elektrischen Induktionsmaschine, mit zwei Störkapazitäten (Fehlerkapazitäten) C_{F}, C_{F}' einerseits zwischen der ersten Anzapfung einer Phasenwicklung U und Masse sowie andererseits einem Sternpunkt der drei Phasenwicklungen U, V, W und Masse;
Fig. 6 ein bei einer derartigen Testanordnung mit einer Fehlerkapazität C_{F} zwischen der ersten Anzapfung und Masse erhaltenen Stromableitungsantwort, wobei sowohl eine Referenzkurve als auch die bei Vorhandensein der Fehlerkapazität sich ergebende Messsignal-Kurve dargestellt sind, wobei diese Darstellung einem Umschalten der Maschine aus dem inaktiven Zustand in den aktiven Zustand entspricht;
Fig. 7 ein entsprechendes di/dt-Singal ähnlich Fig. 6, einmal als Referenz und zum anderen als "Fehler"-Messsignal, bei Vorhandensein einer Fehlerkapazität C_{F}, nun jedoch bei einem Umschalten mit Hilfe des Umrichters von einem aktiven Zustand, mit positiver Größe, in einen anderen aktiven Zustand, mit negativen Wert;
Fig. 8 ein Diagramm ähnlich Fig. 6, wobei nunmehr abgesehen von einem Referenz-Signal Messsignale bei Vorhandensein der Fehlerkapazität C_{F} wie auch bei Vorhandensein einer Fehlerkapazität C_{F}' dargestellt sind; und
Fig. 9A und 9B schematische Diagramme zur Veranschaulichung von statistischen Signal - Kenngrößen von gemessenen Schalt-Einschwingvorgängen, nämlich einerseits Überschwingen (Fig. 9A) und andererseits Eigenfrequenz (Fig. 9B), wobei jeweils eine Referenz, ferner - strichliert - der Verlauf bei einer Fehlerkapazität C_{F}' und überdies - punktiert - der Verlauf bei einer Fehlerkapazität C_{F} veranschaulicht sind, und wobei eine statistische Auswertung von 240 Messungen gegeben ist.

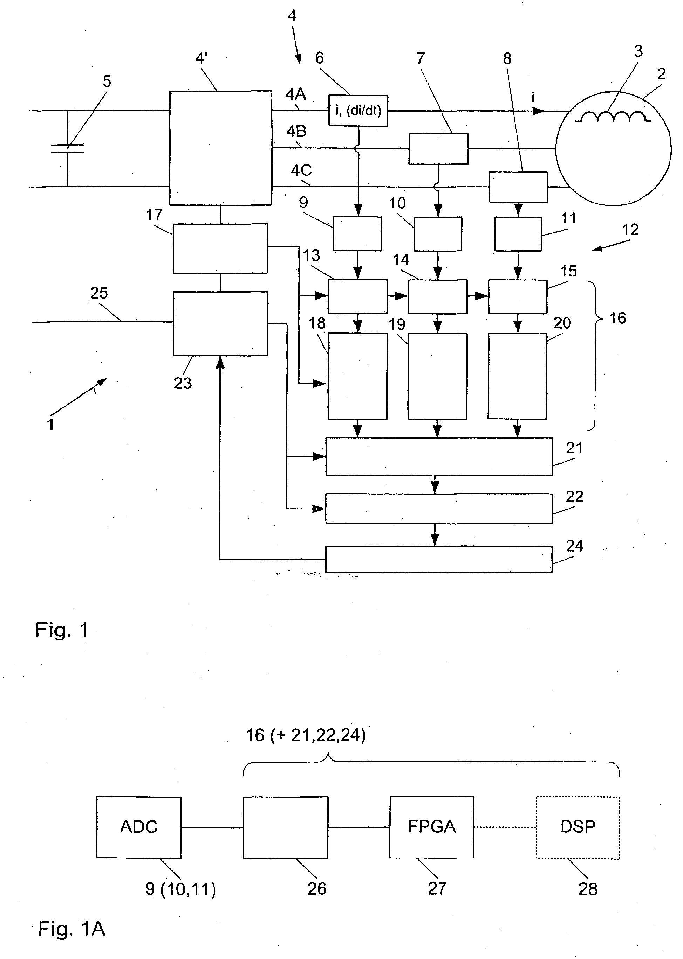

In Fig. 1 ist eine bevorzugte, zur Durchführung des vorliegenden Verfahrens besonders geeignete Ausführungsform einer erfindungsgemäßen Vorrichtung zur Online-Erkennung von Zustandsverschlechterungen von Isolierungen in einer elektrischen Maschine schematisch dargestellt.

Die in Fig. 1 gezeigte Vorrichtung 1 dient dabei zur Online-Überwachung einer elektrischen Maschine 2 (Induktionsmaschine), die ein- oder mehrphasig sein kann, wobei in Fig. 1 beispielsweise drei Phasen vorausgesetzt werden, auch wenn schematisch in Fig. 1 nur eine einzelne Wicklung 3 für die Maschine 2 dargestellt ist. Dieser Maschine 2 ist ein Versorgungskreis oder Speisekreis 4 mit drei Stromleitungen 4A, 4B und 4C, entsprechend den drei Phasen, zugeordnet; in diesem Speisekreis 4 ist auch ein Umrichter 4' vorgesehen, der die entsprechenden Spannungssignale für die Maschine 2 vorsieht; weiters ist ein dem Umrichter 4' zugeordneter Gleichstromanschluss-Kondensator 5 veranschaulicht.

In den einzelnen Phasenleitungen 4A, 4B, 4C sind entsprechende Sensoren 6, 7, 8 angeordnet, die im vorliegenden Fall, für die vorliegende Technologie, zur Erfassung des Stroms i bzw. der zeitlichen Ableitung des Stroms, di/dt, in den einzelnen Phasen 4A, 4B, 4C dienen. Als Stromableitungs-Sensoren können beispielsweise die an sich bekannten Rogowski-Sensoren, auch CDI-Sensoren, verwendet werden. Stromsensoren sind andererseits ebenfalls bekannt und bedürfen hier ebenfalls keiner weiteren Erläuterung.

Die Ausgangssignale der Sensoren 6, 7, 8 werden als Messsignale einer Überabtasteinrichtung 12 zugeführt, die mit A/D-Konvertern (ADCs) 9, 10, 11, je einer für jede Phase 4A, 4B, 4C, ausgeführt ist. Die Abtastrate ist dabei derart hoch, dass eine genaue Bestimmung der Messsignale während des Einschwingens, während der Schaltübergänge, sichergestellt ist. Wie erwähnt kann die Abtastfrequenz dabei mehrere 10 MHz, z.B. 40 MHz, betragen, für manche Anwendungen sind aber auch nur einige wenige MHz, bis zu beispielsweise 10 MHz, ausreichend.

Die Ausgangssignale der ADCs 9, 10, 11 werden sodann Fensterschaltungen 13, 14, 15 zugeführt, die Teil einer Recheneinheit 16 sind und Beobachtungsfenster, d.h. Zeiträume für die auszuwertenden Messsignale nach deren Abtastung, festlegen. Hierzu sind die Fensterschaltungen 13, 14, 15 mit einer Steuereinheit 17 für den Umrichter 4' verbunden, wobei diese Steuereinheit 17 beispielsweise eine Pulsweitenmodulation(PWM)-Steuereinheit ist und entsprechende Schaltbefehle an den Umrichter 4' abgibt, wie dies an sich bekannt ist. Ausgehend von diesen Schalt- oder Steuersignalen wird dann das jeweilige Beobachtungsfenster, also der jeweilige Beobachtungszeitraum, in den Fensterschaltungen 13, 14, 15 fixiert, wobei bei Erreichen des Endes des jeweiligen Fensters die Auswertung, d.h. Zuführung, der Abtastwerte der ADCs 9, 10 und 11 zu eigentlichen Rechnerkomponenten 18, 19, 20 beendet wird.

In diesen Rechnerkomponenten 18, 19, 20, also allgemein in der eigentlichen Recheneinheit 16, werden Kenngrößen hinsichtlich des Einschwingvorgangs der Signale, also konkret hier der Stromssignale oder der die zeitliche Ableitung di/dt des Stroms angebenden Signale, berechnet, wie insbesondere Überschwingen und Eigenfrequenz bzw. Dämpfungskonstante. Überdies kann hier auch der Wert des Signals im stationären, d.h. im eingeschwungenen, Zustand ermittelt werden.

Im Anschluss daran werden die ermittelten Kennwerte einer Vergleichseinheit 21 zugeführt, wo ein Vergleich mit entsprechenden Kenngrößen durchgeführt wird, die zu einem früheren Zeitpunkt in einem Messvorgang bei einer ordnungsgemäß funktionierenden Maschine 2 gewonnen wurden.

Im Anschluss daran erfolgt in einer weiteren Vergleichseinheit 22 ein Vergleich der ermittelten Kenngrößen mit vorgegebenen Schwellenwerten, die beispielsweise über eine Maschinensteuerung 23 zugeführt bzw. vorab in einem (nicht gezeigten) Speicher gespeichert werden können. An die Maschinensteuerung 23 kann auch die erstgenannte Vergleichseinheit 21 angeschlossen sein.

Nach Durchführung der Vergleiche erfolgt in einer Auswerteeinheit 24 die endgültige Auswertung der Signale, d.h. die Erkennung eines (beginnenden) Fehlers und dessen Identifikation, anhand insbesondere der vorhergehenden Vergleichsergebnisse.

In der erstgenannten Vergleichseinheit 21 werden beim Vergleich mit den Parametern der Maschine 2 im normalen Zustand Arbeitspunkt-abhängige Änderungen oder Asymmetrien der Phasen eliminiert. Jede andere Abweichung des Phasensignals vom Normalzustand wird jedoch festgehalten und dem Schwellenwert-Vergleich in der Vergleichseinheit 22 unterzogen. Wenn dort der Signalparameter, also die Kenngröße, oberhalb des Schwellenwerts liegt, wird eine entsprechende Information bezüglich Fehlerdetektion und Identifikation in der Auswerteeinheit 24 erhalten, und das Ergebnis wird beispielsweise der Maschinensteuerung 23 zugeführt, um entsprechende Maßnahmen, wie etwa einen Notbetrieb oder einen Systemabbruch, einzuleiten.

Der Maschinensteuerung 23 wird im Übrigen bei 25 ein Referenzwert für die zu steuernden Vorgänge zugeführt.

In Fig. 1A ist in einer vereinfachten Anordnung, nämlich für eine einzelne Phase, ein Strang für die Überabtastung und Signalverarbeitung einschließlich der vorgenannten Vergleiche und Signalauswertung dargestellt. Im Einzelnen ist dabei ein A/D-Konverter, wie beispielsweise der ADC 9 (ggf. aber auch 10, 11) gezeigt, der über einen Pufferspeicher 26 mit einem Logikbaustein in Form eines frei programmierbaren Verknüpfungsfelds (FPGA) 27 verbunden ist. Der Pufferspeicher 26 hat dabei den Zweck, die vom ADC 9 mit einen hohen Rate abgegebenen Ausgangsdaten zwischenzuspeichern, da der FPGA-Baustein 27 in der Regel eine derart große Datenmenge nicht unmittelbar verarbeiten kann.

Wie weiters in Fig. 1A mit strichlierten Linien veranschaulicht kann für die diversen Berechnungen und Auswertungen, sofern die nicht bereits vom FPGA-Logikbaustein 27 durchgeführt werden können, noch ein digitaler Signalprozessor (DSP) 28 angeschlossen sein.

Wie erwähnt können durch Anlegen verschiedener Umrichter-Schalthandlungen und durch Messen der Systemreaktion an diese steilen, stufenförmigen Spannungsänderungen, bei Anwendung einer Abtastung mit einer hohen Abtastrate, mit einer Frequenz von mehreren MHz, Änderungen in den Kenngrößen der hochfrequenten Stromschwingung detektiert werden.

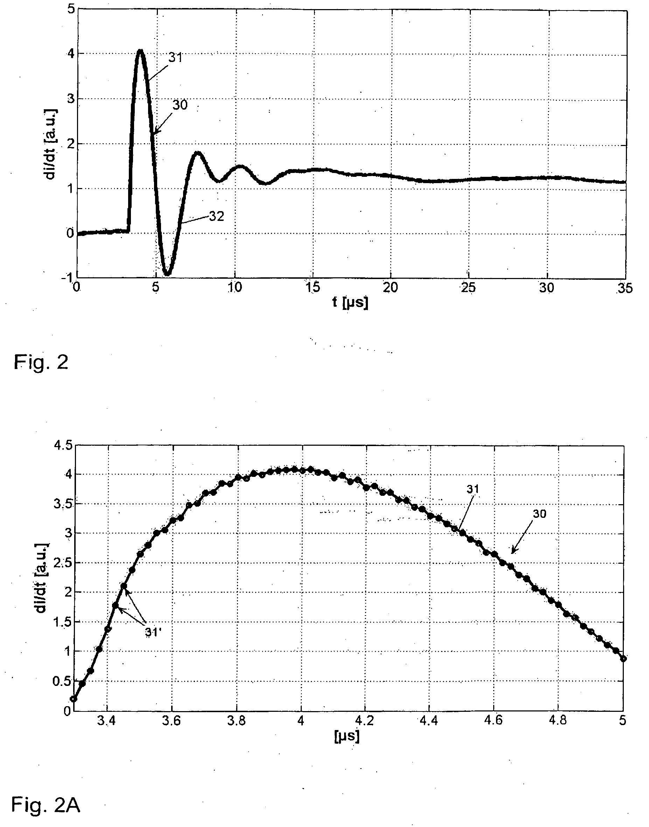

In Fig. 2 ist beispielhaft ein mit Hilfe eines Rogowski-Sensors erhaltenes Messsignal 30 für di/dt, mit beliebigen Amplituden-Einheiten (a.u. - arbitrary units) veranschaulicht. Wie ersichtlich wird hier das System aus dem inaktiven Zustand (Anfangswert 0) durch einen positiven Spannungsimpuls des Umrichters 4' (s. Fig. 1) angestoßen, und der in der jeweiligen Wicklung, z.B. der Wicklung 3 gemäß Fig. 1, hervorgerufene Strom i bzw. dessen zeitliche Ableitung di/dt zeigt dann einen kurzzeitigen Einschwingvorgang, nach dem ein eingeschwungener, stationärer Zustand, beispielsweise bei einem Wert knapp über 1 gemäß Fig. 2, erreicht wird.

Das Messsignal 30 gemäß Fig. 2 wurde wie erwähnt mit Hilfe eines Rogowski-Sensors als Sensor 6 (oder 7 oder 8) erhalten, wobei eine Überabtastung beispielsweise, im vorliegen Fall, mit einer Abtastfrequenz von 40 MHz erfolgt ist.

Diese Überabtastung ist schematisch in Fig. 2A veranschaulicht, wobei konkret in Fig. 2A der erste, positive Überschwinger 31 in einer zeitlich gedehnten Skala (verglichen mit Fig. 2) veranschaulicht ist, und wobei durch Punkte 31' die einzelnen Abtastpunkte veranschaulicht sind. Wie ersichtlich ist dabei die Abtastrate oder -frequenz wesentlich höher als die Frequenz des Einschwingvorgangs, wie beispielsweise im Wesentlich durch den positiven Überschwinger 31 sowie den negativen Überschwinger 32 in Fig. 2 veranschaulicht definiert ist. Die durch diese Überschwinger 31, 32 definierte Eigenfrequenz kann beispielsweise in der Größenordnung 200 kHz liegen, wogegen die Abtastfrequenz wie erwähnt 40 MHz - bei den durchgeführten Tests - betrug.

Die Messung kann an sich bei einem Stillstand der Maschine 2 durchgeführt werden, ebenso wie bei einem Start der Maschine, sie kann aber auch während des Betriebs einer Maschine erfolgen, wenn sich im Zuge der PWM-Ansteuerung der Maschine 2 bei den einzelnen angelegten Spannungsimpulsen jeweilige kurze Einschwingvorgänge 31, 32 für den Wicklungsstrom i bzw. dessen zeitliche Ableitung di/dt ergeben.

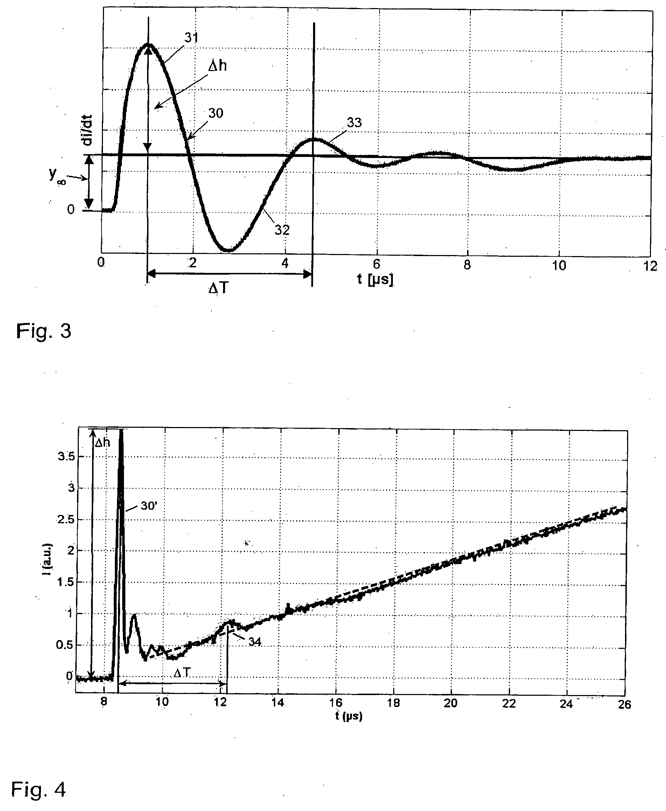

In Fig. 3 ist ein entsprechendes Messsignal 30 für di/dt über der Zeit t veranschaulicht, wobei hier von einem beliebigen Ausgangswert, z.B. einem Wert 0, ein Einschalten der Maschine durch Anlegen eines positiven Spannungssprungs erfolgt, und wobei sich ein Überschwingen über den zu erreichenden stationären Zustand y hinausgehend ergibt. Das erste Überschwingen (Überschwinger 31) ist mit Δh bezeichnet.

Nach einem Überschwingen in den negativen Bereich (Überschwinger 32) erfolgt wieder ein leichtes Überschwingen in den positiven Bereich, bei 33, wodurch sich eine Periode ΔT als inverse Größe zur Eigenfrequenz ergibt. Im gezeigten Beispiel beträgt ΔT beispielsweise ca. 3,5 µs, was eine Eigenfrequenz von 286 kHz bedeutet.

Diese Eigenfrequenz kann somit aus dem in Fig. 3 gezeigten Signalverlauf di/dt über der Zeit t, erhalten mittels eines Rogowski-Sensors und nach Abtastung (siehe Fig. 2A), auf einfache Weise erfasst, d.h. in den Rechenkomponenten 18, 19, 20 ermittelt werden.

Ähnliches gilt auch für das Überschwingen Δh als Wert zwischen der ersten Amplitude beim Einschwingen über den (endgültigen) eingeschwungenen Zustand y_{∞}.

Schließlich kann auch der eingeschwungene Zustand y_{∞}, d.h. der endgültig erhaltene stationäre Wert y_{∞}, gemessen werden, abgesehen davon, dass dieser Wert von vornherein, für eine intakte Maschine 2, für die jeweils angelegte stufenförmige Spannung bekannt ist oder aber, wenn nur eine kurze Messzeit vorausgesetzt wird, durch Mittelung des Messsignals erhalten werden kann.

Bevor nun mehr im Detail auf die einzelnen Auswertvorgänge eingegangen wird, soll noch als alternatives Beispiel für ein Messsignal 30' auf Fig. 4 Bezug genommen werden, in der der - tatsächliche - Strom i, der von einem Sensor 6, 7, 8 erfasst wurde, über der Zeit t aufgetragen ist, wobei ebenfalls die Periode ΔT als Inverse zur Eigenfrequenz für den Einschwingvorgang sowie der Überschwinger Δh veranschaulicht sind. Auch hier sind für die Amplituden wiederum willkürliche Einheiten ("a. u.") gewählt. In Fig. 4 ist weiters bei dem Messsignal 30' mit strichlierter Linie 34, mit positiven Anstieg, eine mittlere Gerade gezeigt, deren zeitliche Ableitung den stationären Zustand veranschaulicht.

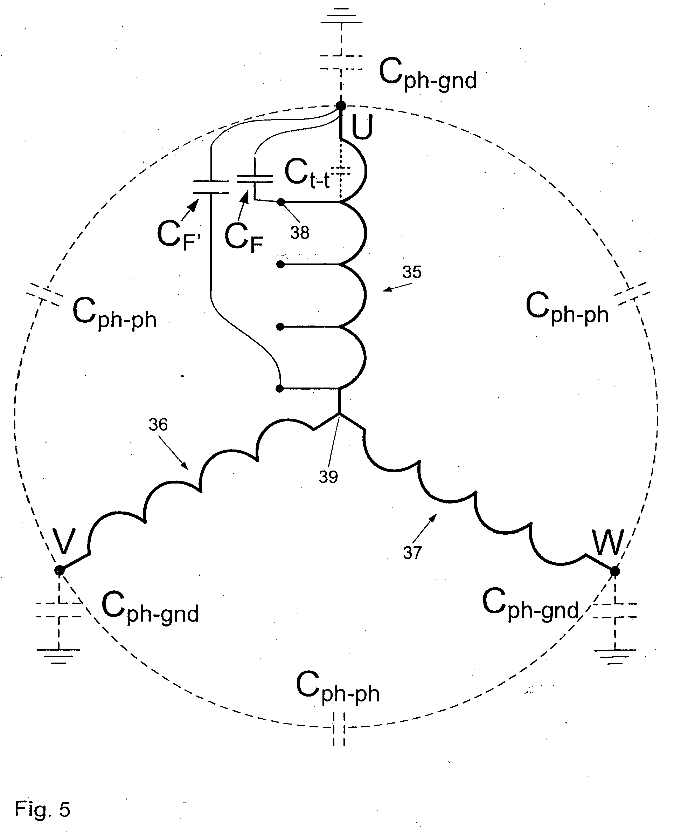

Nachfolgend soll, bevor anhand der Figuren 5 ff. auf konkrete Testergebnisse Bezug genommen wird, kurz auf die Berechnung von Kenngrößen, wie Eigenfrequenz, Überschwingen und stationärer Zustand eingegangen werden.

Die Eigenfrequenz (1/ΔT) der Transientensystem-Antwort, wie sie im Strom-Signal i(t) oder im Signal der zeitlichen Stromableitung di/dt gegeben ist, kann unter Anwendung von verschiedenen an sich bekannten Algorithmen berechnet werden. Ein einfacher und sehr effektiver Weg, insbesondere im Hinblick auf eine Echtzeit-Berechnung, ist die Bestimmung der Extremwerte der Einschwingvorgänge, die im Messsignal 30 bzw. 30' erkennbar sind. Dies kann wie erwähnt auf an sich bekannter Weise, z.B. mit schnellen und robusten Algorithmen, durchgeführt werden und führt zu einer direkten Berechnung der Eigenfrequenz.

Ein anderer, etwas eleganterer und genauerer Berechnungsweg ist jener der Berechnung der inhärenten Frequenzen durch Anwendung einer schnellen Fouriertransformation (FFT - Fast Fourier Transformation).

Eine genaue Selektion der Parameter für die jeweilige Fensterfunktion ist hier ebenfalls von Bedeutung; das Beobachtungsfenster wird zweckmäßig bis zum eingeschwungenen Zustand gelegt, es kann aber auch kürzer sein, um weniger Daten bearbeiten zu müssen. Beispielsweise kann das Fenster nur geringfügig größer als ΔT gewählt werden.

In Fig. 3 und Fig. 4 ist wie erwähnt der Kehrwert der Eigenfrequenz (f₀) als ΔT für beide Sensoren (CDI-Sensor in Fig. 3 und Absolutwert-Stromsensor in Fig. 4) angegeben.

Die selben Verfahren, die zur Berechnung der Eigenfrequenz. f₀ = 1/ΔT bei Bestimmung der Extremwerte des Transientenverlaufs des Stroms oder der zeitlichen Ableitung di/dt des Stroms mit Hilfe von schnellen, einfachen Algorithmen angewendet werden, können zur Berechnung von Überschwingwerten des Signals angewendet werden. Wenn der Signalverlauf von Fig. 3 (zeitliche Ableitung des Stroms, di/dt) betrachtet wird, so repräsentiert die Differenz zwischen dem ersten Extremwert und dem eingeschwungenen Zustand den ersten Überschwinger 31. In Fig. 3 ist der Wert für den ersten positiven Überschwinger mit Δh (in Fall der Verwendung von CDI-Sensoren) markiert. Wenn Standardsensoren eingesetzt werden, die den absoluten Stromwert über der Zeit messen, s. Fig. 4, so ist ersichtlich, dass das Ausschwingen der Transientensignalverläufe einem nahezu geraden Verlauf folgt. Es wird daher kein stationärer Signalzustand während der Anlegung von Spannungsstufen im hierzu betrachteten Zeitbereich von einigen Mikrosekunden erreicht. Während eines aktiven Schaltens steigt der Strom in dieser Zeit, in diesem Zeitfenster, kontinuierlich an, s. Signal 34, und nur die zeitliche Ableitung des Stroms erreicht einen stationären Wert. Der Maximalwert während des Schalt-Einschwingvorgangs im Stromsignal relativ zum letzten Stromwert vor Änderung des Schaltzustandes kann als erstes positives Überschwingen Δh angesehen werden (Fig. 4).

Wenn der Spannungssprung lange genug angelegt wird, nämlich lange genug, dass der stationäre Zustand der zeitlichen Ablenkung des Stromes erreicht wird, kann der Wert y_{∞} des stationären Zustands des Signals selbstverständlich einfach bestimmt werden. Im Fall von Sensoren für die zeitliche Ableitung des Stroms (Rogowski-Sensoren) ist der Wert des stationären Zustands der letzte gemessene Wert bei Anlegen einer konstanten Spannungsstufe. Dies könnte auch ohne hochfrequente A/D-Konverter, direkt, bewerkstelligt werden, wobei die Signalgenauigkeit erhöht werden kann, wenn der Wert des stationären Zustands durch Mittelung über mehrere derartige letzte Messwerte erfasst wird.

Wenn Sensoren verwendet werden, die den Strom direkt messen, ist der interessierende Wert der stationäre Zustand der Neigung der Stromkurve, s. Kurventeil 34 in Fig. 4. Hier kann die Berechnung derart verfolgen, dass zumindest zwei Stromwerte genommen werden, wobei der zeitliche Unterschied zwischen den beiden Stromwerten groß genug ist, um eine genaue Bestimmung der zeitlichen Ableitung des Stroms, also die Steigung der Geraden 34 in Fig. 4, zu ermöglichen.

Ein Vorteil von überabtastenden A/D-Konvertern 9, 10, 11 liegt auch in der Möglichkeit der Anwendung von Mittelungstechniken, wodurch die Genauigkeit der Erkennung erhöht werden kann.

Im Fall einer sich verschlechternden Isolierung wird sich der stationäre Zustandwert im Vergleich zu jenen bei einer intakten Maschine nicht ändern. Sobald jedoch ein Windungs-Kurzschluss, also ein Kurzschluss von Windung zu Windung, auftritt, zeigen die Messungen, dass sich der Wert des stationären Zustands wesentlich ändert, selbst wenn nur eine Windung in einer einzelnen Phase kurzgeschlossen wird.

Die Berechnung des Werts y_{∞} des stationären Zustands eignet sich demgemäß insbesondere zur Berechnung eines bereits gegebenen Fehlers an der Isolierung.

Es wurden praktische Tests an einer 5,5 kW-Kurzschlussläufer-Induktionsmaschine durchgeführt, wobei Abgriffe verschiedener Windungen der drei Wicklungen der Maschine zugänglich waren. Durch Verbinden derartiger Abgriffe mit einem entsprechenden Anschluss der Maschine, ist es möglich, eine verschieden hohe Anzahl von Windungen kurzzuschließen, um einen noch nicht zur Zerstörung führenden Inter-Turn-Isolierungsfehler der Stators zu simulieren. Wenn nun anstatt einer direkten Verbindung eine zusätzliche Kapazität, eine Fehlerkapazität C_{F}, zwischen entsprechenden Anschlüssen eingefügt wird, wird eine verschlechterte Isolierung von Windung zu Windung simuliert. Eine derartige Vorgangsweise ist in Fig. 5 schematisch veranschaulicht, wobei drei Wicklungen 35, 36, 37, entsprechend Phasen U, V, W, gezeigt sind. Mit strichlierten Linien sind einerseits die Kapazitäten zwischen den einzelnen Phasen, Cₚₕ₋ₚₕ, und andererseits die Kapazitäten zwischen den einzelnen Phasen und Masse, C_{ph-gnd,} veranschaulicht. Weiters ist mit punktierter Linie eine Kapazität Cₜ₋ₜ als normale Kapazität zwischen zwei aufeinanderfolgenden Windungen schematisch eingezeichnet.

Zusätzlich sind nun zwei Fehlerkapazitäten C_{F}, C_{F}' dargestellt, zum einen eine Fehlerkapazität C_{F} zwischen einem ersten Abgriff 38 der Wicklung 35 und dem Phasenanschluss U, und zum anderen eine Fehlerkapazität C_{F}' zwischen dem Sternpunkt 39 und dem Phasenanschluss U. Die zusätzliche Kapazität C_{F} bzw. C_{F}' parallel zur Windungskapazität, z.B. C_{t-t,} erhöht die (Fehler-)Kapazität aufgrund der Windungsisolierung. Ein entsprechender Anstieg der Kapazität kann bei einer Verschlechterung der dielektrischen Eigenschaften der Isolierung festgestellt werden. Beim Test wurden weiters zur näheren Identifizierung der Eigenschaften des Isolierungssystems der Induktionsmaschine die Phasen-Phasen-Kapazitäten Cₚₕ₋ₚₕ mit 500 pF und die Phase-Masse-Kapazität C_{ph-gnd} mit 1 nF bestimmt.

Bei den Tests wurde die Übertastung mit einer Frequenz von 40 MHz, mit Hilfe von 16 Bit-A/D-Konvertern durchgeführt. Die Kommunikation mit einer FPGA-Komponente 27 erfolgt über Datenpuffer 2 6 (Fig. 1A).

In ersten Tests, vgl. Fig. 5, wurde eine Fehlerkapazität C_{F} zwischen dem ersten Abgriff 38 der U-Wicklung 35 und dem Phasenanschluss eingefügt.

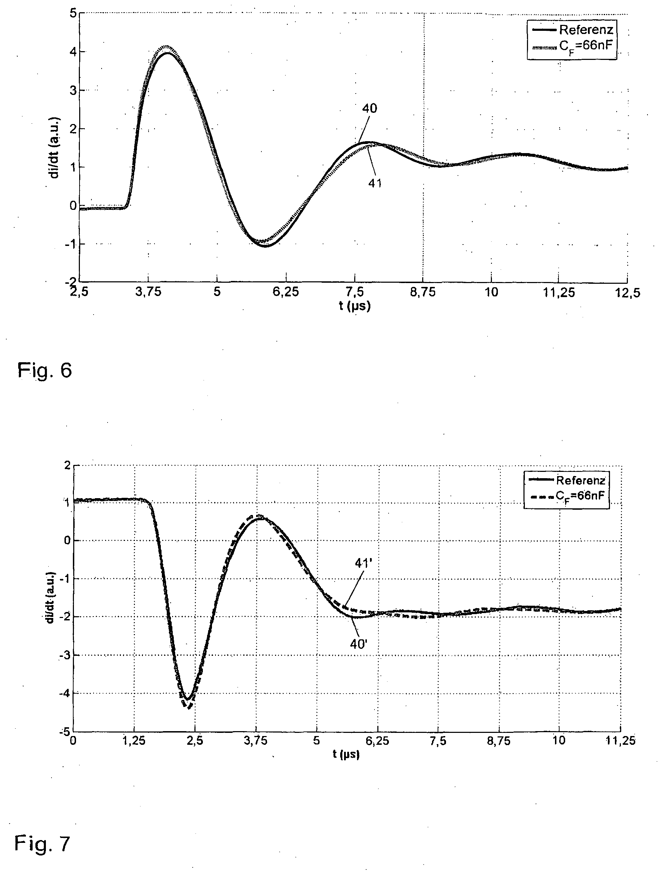

In Fig. 6 ist der entsprechend erhaltene Signalverlauf, gemessen mit einem Rogowski-Sensor für die zeitliche Ableitung des Stroms di/dt, mit der Kurve 41 veranschaulicht, wobei eine Referenzkurve 40 für den Signalverlauf bei intakter Maschine ebenfalls veranschaulicht ist. Wie ersichtlich ergeben sich unterschiedliche Signalverläufe für die beiden Kurven 40 (Referenz) und 41 (mit Fehlerkapazität C_{F}). Die Fehlerkapazität betrug dabei beispielhaft C_{F} = 66 nF.

Aus dem Signalverlauf von Fig. 6 ergibt sich weiters auch, dass wie erwartet - die Änderung in der Windungskapazität nicht auf Basis der Messsignal-Werte im stationären Zustand erfasst werden kann, da die beiden Signalverläufe im eingeschwungen Zustand idente Werte liefern. Es ist jedoch aus Fig. 6 ein klarer Unterschied hinsichtlich Überschwingen und Eigenfrequenz erkennbar. Dieser Unterschied ist nur erkennbar, wenn der Spannungszeiger des aktiven Schaltzustands in die Phasenachse der "verschlechterten" Phase U (in diesem Beispiel) zeigt. Zu erwähnen ist auch, dass die Schalt-Einschwingvorgänge - wie sich gezeigt hat - nur sehr geringe statistische Variationen zeigen. Jeder in den vorliegenden Figuren gezeigt Verlauf eines Signals entspricht einem auf Basis von 240 Messungen erhaltenen mittleren Wert.

Zum Vergleich ist in Fig. 7 ein Signalverlauf - Referenz-Signal 40' und Messsignalverlauf 41' - für den Fall dargestellt, dass ein Schaltvorgang mit Hilfe des Umrichters 4' von einem aktiven Zustand im positiven Bereich in einen aktiven Zustand im negativen Bereich (z.B. von ca. +1 auf ca. -2) erfolgt. Demgegenüber ist in Fig. 6 der Verlauf der Signale 40, 41 bei einem Schaltvorgang des Umrichters 4' aus einem inaktiven Zustand 0 in einem aktiven Zustand (stationärer Wert ca. +1) veranschaulicht.

Auch im Fall der Fig. 7 wurde eine Fehlerkapazität C_{F} = 66 nF zwischen dem ersten Abgriff 38 der Wicklung 35 und dem Phasenanschluss U geschaltet. Auch hier sind einerseits eindeutig das (zuerst negative und dann positive) Überschwingen des Signalverlaufs 41' im Vergleich zum Referenz-Signal 40' erkennbar, ebenso wie die Änderung der Eigenfrequenz im Hinblick auf eine Verschiebung des Zeitintervalls ΔT.

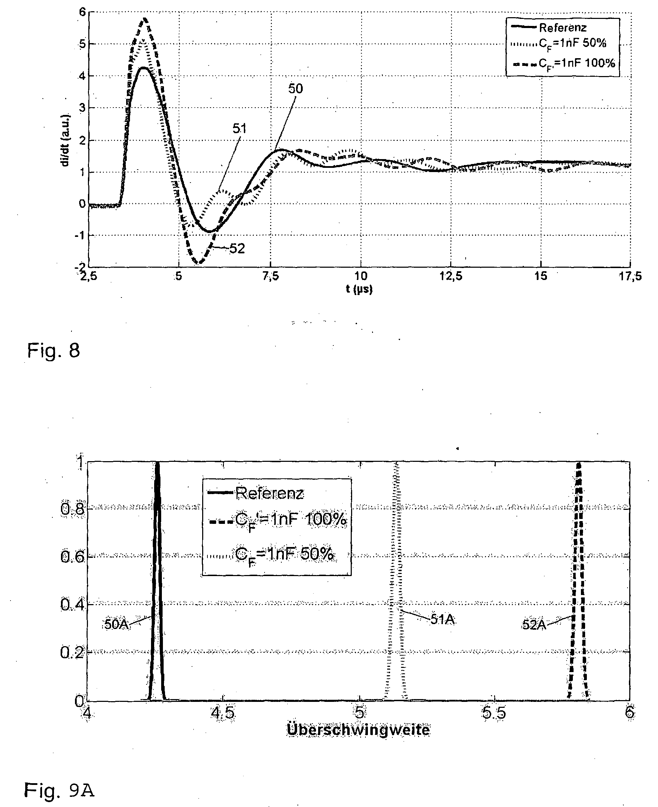

In einem anderen Test wurden vergleichbare Messungen bei einerseits einer eingefügten Fehlerkapazität C_{F} zwischen einem Abgriff in der Mitte der Wicklung der Phase U (50 %-Kurzschluss) bzw. zwischen dem Sternpunkt 39 und dem Phasenanschluss (Fehlerkapazität C_{F}', entsprechend 100 %-Kurzschluss) vorgenommen, wobei die Fehlerkapazitäten jeweils ein 1 nF betrugen. Aus den entsprechenden Signalverläufen in Fig. 8, wiederum gemessenen mit Rogowski-Sensoren (di/dt-Sensoren) und erhalten nach Überabtastung mit 40 MHz, sind die Unterschiede zwischen dem Referenz-Signal 50 und dem Signal 51 bei einem 50 %igen Kurzschluss (Fehlerkapazität C_{F}), einerseits sowie dem Signal 52 bei einem 100 %igen Kurzschluss, Fehlerkapazität C_{F}', deutlich zu erkennen. Wie auch dabei ersichtlich ist, kann bei den dargestellten Verläufen unter Erfassung der Änderungen die Eigenfrequenz ungefähr nach der ersten Periode des Einschwingvorgangs festgestellt werden.

Um die Verlässlichkeit der erfassten Schalt-Einschwingvorgänge zu untersuchen, wurden die statistischen Eigenschaften der Sensorsignale untersucht. Es wurden dabei bei jeder Anordnung wie erwähnt 240 Messungen an der Maschine bzw. Wicklung vorgenommen, und die Ergebnis bzw. Signalparameter wurden verglichen.

In Entsprechung zu den Signalverläufen in Fig. 8 ist in den Figuren 9A (bezüglich Überschwingweite) und 9B (bezüglich Frequenz bzw. Eigenfrequenz) schematisch eine normalisierte Wahrscheinlichkeitsdichte der Signaleigenschaften veranschaulicht, wie sie von den Schalt-Einschwingvorgängen wie erläutert erhalten werden. Die Überschwingweite (Δh in Fig. 3) ist für die Referenz bei ca. 4,3 gezeigt (Überschwinger 50A), der erste Überschwinger 51A für das Signal 51 ist in Fig. 9A bei einer Überschwingweite von etwas über 5 und der erste Überschwinger 52A im Signal 52 ist in Fig. 9A mit einer Überschwingweite von ca. 5,8 dargestellt.

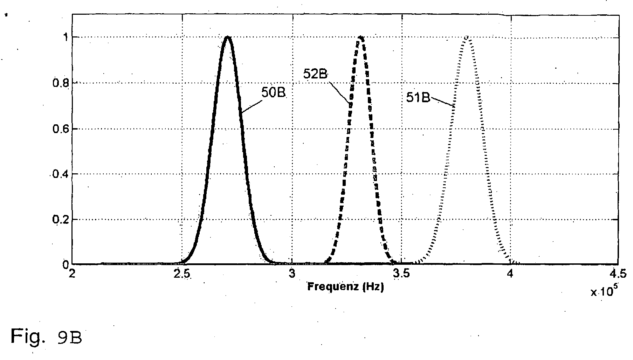

Was die Eigenfrequenz betrifft, so sind entsprechende Frequenzwerte 50B, 51B, 52B in Fig. 9B bei ca. 0,27 MHz für die Eigenfrequenz bei der Referenzkurve 50, bei ca. 0,38 MHz für die Signalkurve 51 bei 50 %-Kurzschluss, und für den 100 %-Kurzschluss, Signal 52 in Fig. 8, bei einem ungefähren Wert von 0,33 MHz (bei 52B) veranschaulicht.

Bei den Tests wurden keine komplizierten Algorithmen, sondern einfach mathematische Methoden zur Bestimmung von Überschwingen und Eigenfrequenz als charakteristische Kenngrößen angewendet. Wie aus Fig. 9A und 9B ersichtlich ist, haben die ermittelten Kenngrößen eine geringe Varianz, was eine zuverlässige und rasche Detektion von sogar kleinsten Änderungen in der Windungskapazität ermöglicht.

Wie erwähnt ist es zweckmäßig, zur Überwachung des laufenden Windungszustands in einem Online-Betrieb die Signal-Kenngrößen bei einer intakten Maschine 2, einer ordnungsgemäß funktionierenden Maschine, beispielsweise in einer Kommissionierungsphase zu ermitteln. Es ist dann in der Folge jedoch darauf zu achten, dass keine Änderungen in Widerstands- und Induktivitäts- sowie Kapazitätswerten, wie etwa aufgrund von Änderungen in der Verkabelung, eingeführt werden.

Es ist auch möglich, bei den Messungen die Dämpfungskonstante der transienten Eigenschwingung - zusätzlich zur oder anstatt der Eigenfrequenz 1/ΔT - als Kenngröße zu ermitteln. Hierbei kann beispielsweise derart vorgegangen werden, dass aus Größe und Zeitpunkt der einzelnen Überschwinger und Unterschwinger das Abklingverhalten der transienten Eigenschwingung mittels einfacher Exponentialfunktionen approximiert wird.

## Patentansprüche

1. Verfahren zum Testen einer Isolierung in einer elektrischen Maschine (2) während des Betriebs der Maschine (2), wobei eine Spannung an die Wicklung(en) (3) der Maschine (2) angelegt und ein dadurch ausgelöster Einschwingvorgang mit einer im Vergleich zu den für ein Einschwingen charakteristischen Frequenzen hohen Frequenz überabgetastet wird, **dadurch gekennzeichnet, dass** zur Erkennung einer Zustandsverschlechterung der Isolierung mit Hilfe eines Umrichters (4') eine stufenförmige Spannung an die Wicklung(en) (3) der Maschine (2) angelegt und der dadurch hervorgerufene Strom (i) und/oder dessen zeitliche Ableitung (di/dt) als Messsignal mit Hilfe von wenigstens einem Sensor (6, 7, 8) erfasst wird, welches überabgetastet wird, wonach das durch die Überabtastung erhaltene Signal hinsichtlich Kenngrößen des Einschwingvorgangs, wie Überschwingen (Δh) und/oder Eigenfrequenz (1/ΔT) und/oder Dämpfungskonstante, zur Erkennung einer etwaigen Isolierungsverschlechterung ausgewertet wird.

2. Verfahren nach Anspruch 1, **dadurch gekennzeichnet, dass** die durch die Auswertung erhaltenen Kenngrößen mit entsprechenden Kenngrößen verglichen werden, die in einem früheren Messvorgang, bei ordnungsgemäß funktionierender Maschine, gewonnen wurden.

3. Verfahren nach Anspruch 1 oder 2, **dadurch gekennzeichnet, dass** die erhaltenen Kenngrößen mit vorgegebenen Schwellenwerten verglichen werden, bei deren Überschreiten auf einen Fehlerzustand entschieden wird.

4. Verfahren nach einem der Ansprüche 1 bis 3, **dadurch gekennzeichnet, dass** die Eigenfrequenz (1/ΔT) durch Bestimmung des zeitlichen Abstands zwischen aufeinanderfolgenden über abgetasteten Extremwerten des Messsignals ermittelt wird.

5. Verfahren nach einem der Ansprüche 1 bis 4, **dadurch gekennzeichnet, dass** das Überschwingen (Δh) als Differenz zwischen einem Wert im eingeschwungenen Zustand und einem, gegebenenfalls ersten, Extremwert im Signal ermittelt wird.

6. Verfahren nach einem der Ansprüche 1 bis 5, **dadurch gekennzeichnet, dass** als Kenngröße zur Erkennung von tatsächlichen Isolierungsfehlern der eingeschwungene Zustand (y_{∞}) des Signals herangezogen wird.

7. Verfahren nach Anspruch 6, **dadurch gekennzeichnet, dass** der Wert (y_{∞}) des Signals im eingeschwungenen Zustand im Fall der Erfassung der zeitlichen Ableitung des hervorgerufenen Stroms als der letzte gemessene Wert bei Anlegen einer konstanten Spannung ermittelt wird.

8. Verfahren nach Anspruch 6, **dadurch gekennzeichnet, dass** der Wert (y_{∞}) des Signals im eingeschwungenen Zustand im Fall der direkten Erfassung des hervorgerufenen Stroms über zwei beabstandete Abtastwerte und die durch diese definierte Steigung im Signal ermittelt wird.

9. Verfahren nach einem der Ansprüche 1 bis 8, **dadurch gekennzeichnet, dass** mehrere Messvorgänge mit Anlegen einer stufenförmigen Spannung vorgenommen werden und eine statistische Auswertung der erhaltenen Ergebnisse durchgeführt wird.

10. Vorrichtung zum Testen einer Isolierung in einer elektrischen Maschine (2) während des Betriebs der Maschine (2), wobei der elektrischen Maschine (2) ein Speisekreis (4) sowie zumindest ein Sensor (6, 7, 8) in einer Stromleitung (4A, 4B, 4C) zur Maschine (2) zugeordnet sind, und wobei Mittel (4') zum Anlegen einer Spannung an die Wicklung(en) (3) der Maschine (2) sowie eine Überabtasteinrichtung (12) zum Überabtasten eines mit Hilfe des Sensors (6, 7, 8) erhaltenen Messsignals mit einer relativ zu Einschwingvorgängen, die bei Anliegen der Spannung ausgelöst werden, vergleichsweise hohen Frequenz vorgesehen sind, **dadurch gekennzeichnet, dass** der Speisekreis (4) einen Umrichter (4') enthält, der zugleich die Mittel (4') zum Anlegen einer Spannung enthält, wobei der Umrichter (4') zum Erkennen einer etwaigen Isolierungsverschlechterung eine stufenförmige Spannung an die Wicklung(en) (3) der Maschine (2) anlegt, dass der Sensor (6, 7, 8) bei Anlegen der stufenförmigen Spannung den in einer Wicklung (3) der Maschine (2) hervorgerufenen Strom (i) oder dessen zeitliche Ableitung (di/dt) als Messsignal erfasst, das überabgetastet wird, und dass die erhaltenen Abtastwerte einer Recheneinheit (16) zur Ermittlung von Kenngrößen des Einschwingvorgangs beim Anlegen der stufenförmigen Spannung, wie Überschwingen (Δh) und/oder Eigenfrequenz (1/ΔT) und/oder Dämpfungskonstante, zur Erkennung einer etwaigen Isolierungsverschlechterung zugeführt werden.

11. Vorrichtung nach Anspruch 10, **gekennzeichnet durch** wenigstens eine Vergleichseinheit (21, 22) zum Vergleichen der erhaltenen Kenngrößen mit entsprechenden gespeicherten Kenngrößen der Maschine bei ordnungsgemäßer Funktion und/oder mit einem vorgegebenen Schwellwert.

12. Vorrichtung nach Anspruch 11, **dadurch gekennzeichnet, dass** an die Vergleichseinheit (21, 22) eine Auswerteeinheit (24) zur Erkennung und Identifizierung von Isolierungsverschlechterungen und ggfs. -fehlern angeschlossen ist.

13. Vorrichtung nach einem der Ansprüche 10 bis 12, **gekennzeichnet durch** eine Fensterschaltung (13, 14, 15) zwischen der Überabtasteinrichtung (12) und der eigentlichen Recheneinheit (16), wobei die Fensterschaltung (13, 14, 15) mit einem Steuereingang an eine dem Umrichter ansteuernden Steuereinheit (17) angeschlossen ist und ein vorgegebenes Beobachtungsfenster, beginnend mit einem Steuersignal der Steuereinheit (17), festlegt, in dem die Abtastwerte der Weiterverarbeitung zugeführt werden.

14. Vorrichtung nach einem der Ansprüche 10 bis 13, **dadurch gekennzeichnet, dass** die Recheneinheit (16) mit einem frei programmierbaren Verknüpfungsfeld (FPGA) (27) ausgeführt ist.

15. Vorrichtung nach einem der Ansprüche 10 bis 14, **dadurch gekennzeichnet, dass** die Recheneinheit (16) einen digitalen Signalprozessor (DSP) (28) aufweist.

## Claims

1. A method for testing an insulation in an electrical machine (2) during operation of the machine (2), wherein a voltage is applied to the winding(s) (3) of the machine (2) and a transient response triggered as a result is oversampled at a frequency which is relatively high when compared to the characteristic frequencies for a transient oscillation, **characterized in that** in order to detect a possible deterioration in the condition of the insulation, a stepped voltage is applied to the winding (s) (3) of the machine (2) by means of an inverter (4'), and the resulting current (i) and/or the time derivative thereof (di/dt) is detected as a measurement signal by means of at least one sensor (6, 7, 8), which measurement signal is oversampled, following which the signal obtained by the oversampling is analysed with regard to characteristic parameters of the transient process, such as overshoot (Δh) and/or natural frequency (1/ΔT) and/or damping constant, in order to detect a possible deterioration of the insulation.

2. The method according to Claim 1, **characterized in that** the characteristic parameters obtained from the analysis are compared with the corresponding characteristic parameters which were obtained in a previous measurement procedure on a properly functioning machine.

3. The method according to Claim 1 or 2, **characterized in that** the characteristic parameters obtained are compared with predefined threshold values, which, if exceeded, would result in an error condition being decided.

4. The method according to any one of Claims 1 to 3, **characterized in that** the natural frequency (1/ΔT) is determined by calculating the time interval between consecutive oversampled extreme values of the measurement signal.

5. The method according to any one of Claims 1 to 4, **characterized in that** the overshoot (Δh) is determined as the difference between a value in the steady-state condition and a, possibly first, extreme value in the signal.

6. The method according to any one of Claims 1 to 5, **characterized in that** in order to detect actual insulation faults, the steady state condition (y_{∞}) of the signal is used as a characteristic parameter.

7. The method according to Claim 6, **characterized in that** in the case where the time derivative of the induced current is detected, the value (y_{∞}) of the signal in the steady-state condition is determined as the last measured value when a constant voltage is applied.

8. The method according to Claim 6, **characterized in that** in the case of direct detection of the induced current in the steady-state condition, the value (y_{∞}) of the signal is determined via two separate samples and the slope defined by them in the signal.

9. The method according to any one of Claims 1 to 8, **characterized in that** a plurality of measurements is made based on application of a stepped voltage, and a statistical evaluation of the results obtained is carried out.

10. A device for testing an insulation in an electrical machine (2) during operation of the machine (2), wherein a supply circuit (4) and at least one sensor (6, 7, 8) in a current supply conductor (4A, 4B, 4C) to the machine (2), are associated with the electrical machine (2), and wherein means (4') are provided for applying a voltage to the winding(s) (3) of the machine (2) and an oversampling device (12) is provided for oversampling a measurement signal, obtained using the sensor (6, 7, 8), at a comparatively high frequency relative to transient processes that are triggered by the application of the voltage, **characterized in that** the supply circuit (4) contains an inverter (4'), which in turn contains the means (4') for applying a voltage, wherein said inverter (4'), in order to detect a possible deterioration of the insulation, applies a stepped voltage to the winding(s) (3) of the machine (2), that the sensor (6, 7, 8), when applying the stepped voltage, detects the current (i) induced in at least one winding (3) of the machine (2) or the time derivative (di/dt) thereof as a measurement signal that is oversampled, and that the samples obtained are supplied to a computer unit (16) for determining characteristic parameters of the transient process on application of the stepped voltage, such as overshoot (Δh) and/or natural frequency (1/ΔT) and/or damping constant, in order to detect a possible deterioration of an insulation.

11. The device according to Claim 10, **characterized by** at least one comparator unit (21, 22) for comparing the characteristic parameters obtained with corresponding stored characteristic parameters of the machine when functioning properly, and/or with a pre-specified threshold value.

12. The device according to Claim 11, **characterized in that** the comparator unit (21, 22) is connected to an evaluation unit (24) for the detection and identification of deteriorations and, where appropriate, faults in insulations.

13. The device according to any one of Claims 10 to 12, **characterized by** a window circuit (13, 14, 15) between the oversampling device (12) and the computing unit proper (16), wherein the window circuit (13, 14, 15) has a control input connected to a control unit (17) controlling the inverter and specifies a predefined observation window starting with a control signal from the control unit (17), in which the samples are supplied to a further processing stage.

14. The device according to any one of Claims 10 to 13, **characterized in that** the computing unit (16) is embodied with a field-programmable gate array (FPGA) (27).

15. The device according to any one of Claims 10 to 14, **characterized in that** the computing unit (16) comprises a digital signal processor (DSP) (28).

## Revendications

1. Procédé pour tester une isolation dans une machine électrique (2) pendant le fonctionnement de la machine (2), dans lequel une tension est appliquée à la ou aux bobine (s) (3) de la machine (2), et un phénomène transitoire, déclenché par cette tension, est saturé avec une fréquence élevée par comparaison avec les fréquences caractéristiques d'un effet transitoire, **caractérisé en ce que**, pour reconnaître une dégradation de l'état de l'isolation à l'aide d'un convertisseur (4'), une tension par paliers est appliquée à la ou aux bobine(s) (3) de la machine (2), et que l'intensité (i) du courant qui en résulte, et/ou sa dérivée en fonction du temps (di/dt) sont détectées en tant que signal de mesure à l'aide d'au moins un capteur (6, 7, 8), lequel est saturé, ce après quoi le signal obtenu grâce à cette saturation est évalué pour ce qui est des paramètres caractéristiques du phénomène transitoire, tels que les suroscillations (Δh) et/ou la fréquence propre (1/ΔT) et/ou le coefficient d'amortissement, dans le but de reconnaître une éventuelle dégradation de l'isolation.

2. Procédé selon la revendication 1, **caractérisé en ce que** les paramètres caractéristiques obtenus grâce au test sont comparés à des paramètres caractéristiques correspondants, qui ont été obtenus au cours d'une opération préalable de mesure, sur une machine dont le fonctionnement est correct.

3. Procédé selon la revendication 1 ou 2, **caractérisé en ce que** les paramètres caractéristiques obtenus sont comparés à des valeurs seuils prédéfinies, dont un dépassement permet de conclure à un état de défaut.

4. Procédé selon l'une des revendications 1 à 3, **caractérisé en ce que** la fréquence propre (1/ΔT) est déterminée par une détermination de l'écart temporel entre des valeurs extrêmes, saturées et successives, du signal de mesure.

5. Procédé selon l'une des revendications 1 à 4, **caractérisé en ce que** la suroscillation (Δh) est déterminée par la différence entre une valeur à l'état permanent et une valeur extrême, éventuellement la première, du signal.

6. Procédé selon l'une des revendications 1 à 5, **caractérisé en ce qu'**on fait appel, en tant que paramètre caractéristique pour reconnaître des défauts effectifs de l'isolation, à l'état en régime permanent (y_{∞}) du signal.

7. Procédé selon la revendication 6, **caractérisé en ce que** la valeur (y_{∞}) du signal à l'état stationnaire est, dans le cas de la détermination de la dérivée en fonction du temps de l'intensité du courant obtenue, déterminée par la dernière valeur mesurée lors de l'application d'une tension constante.

8. Procédé selon la revendication 6, **caractérisé en ce que** la valeur (y_{∞}) du signal à l'état stationnaire est, dans le cas de la détermination directe de l'intensité du courant obtenue, déterminée par l'intermédiaire de deux échantillons espacés, et par la pente définie par ces derniers dans le signal.

9. Procédé selon l'une des revendications 1 à 8, **caractérisé en ce que** plusieurs opérations de mesure sont effectuées, avec application d'une tension par paliers, et une évaluation statistique des résultats obtenus est mise en oeuvre.

10. Dispositif pour tester une isolation dans une machine électrique (2) pendant le fonctionnement de la machine (2), dans lequel un circuit d'alimentation (4), ainsi qu'au moins un capteur (6, 7, 8) se trouvant sur une ligne de courant (4A, 4B, 4C) allant vers la machine (2), sont affectés à la machine électrique (2), et dans lequel sont prévus des moyens (4') pour appliquer une tension à la ou aux bobine (s) (3) de la machine (2), ainsi qu'un dispositif de saturation (12) pour saturer un signal de mesure obtenu à l'aide du capteur (6, 7, 8), à une fréquence relativement élevée par rapport aux phénomènes transitoires qui sont déclenchés lors de l'application de la tension, **caractérisé en ce que** le circuit d'alimentation (4) comprend un convertisseur (4'), qui en outre contient les moyens (4') destinés à appliquer une tension, le convertisseur (4') appliquant, pour reconnaître une éventuelle dégradation de l'isolation, une tension par paliers à la ou aux bobines (s) (3) de la machine (2) ; que le capteur (6, 7, 8) détecte, lors de l'application de la tension en paliers, sous forme d'un signal de mesure, l'intensité (i) du courant créé dans une bobine (3) de la machine (2) ou sa dérivée en fonction du temps (di/dt), signal de mesure qui est saturé ; et que les échantillons obtenus sont envoyés à une unité de calcul (16) pour déterminer des paramètres caractéristiques du phénomène transitoire lors de l'application de la tension par paliers, tels qu'une suroscillation (Δh) et/ou une fréquence propre (1/ΔT) et/ou un coefficient d'amortissement, pour reconnaître une éventuelle dégradation de l'isolation.

11. Dispositif selon la revendication 10, **caractérisé par** au moins une unité de comparaison (21, 22) destinée à comparer les paramètres caractéristiques obtenus à des paramètres caractéristiques stockés correspondants de la machine quand elle fonctionne convenablement, et/ou à une valeur seuil prédéfinie.

12. Dispositif selon la revendication 11, **caractérisé en ce qu'**une unité d'évaluation (24), destinée à reconnaître et à identifier des dégradations et éventuellement des défauts de l'isolation, est connectée à l'unité de comparaison (21, 22).

13. Dispositif selon l'une des revendications 10 à 12, **caractérisé par** un circuit-fenêtre (13, 14, 15) entre le dispositif de saturation (12) et l'unité de calcul proprement dite (16), le circuit-fenêtre (13, 14, 15) étant connecté, par une entrée de commande, à une unité de commande (17) qui excite le convertisseur, et définit une fenêtre d'observation prédéfinie, commençant par un signal de commande de l'unité de commande (17), fenêtre dans laquelle les échantillons sont envoyés pour traitement ultérieur.

14. Dispositif selon l'une des revendications 10 à 13, **caractérisé en ce que** l'unité de calcul (16) est réalisée avec un circuit intégré pré-diffusé programmable (FPGA) (27).

15. Dispositif selon l'une des revendications 10 à 14, **caractérisé en ce que** l'unité de calcul (16) comprend une unité de traitement numérique du signal (28).
